# EUROPEAN PATENT SPECIFICATION

(11) **EP 0 313 220 B1**
(45) Date of publication and mention of the grant of the patent: **11.05.1994**
(21) Application number: 88308788.4
(22) Date of filing: 22.09.1988
(51) Int. Cl.: G03F 7/038, C08F 8/44

(54) **Photopolymers**
Photopolymere
Photopolymères

(30) Priority: 17.10.1987 GB 8724372; 24.02.1988 GB 8804277
(43) Date of publication of application: 26.04.1989
(73) Proprietor: AUTOTYPE INTERNATIONAL LIMITED, Wantage Oxon OX12 7BZ (GB)
(72) Inventor: Balfour, Ross Alexander, Wantage Oxfordshire OX12 0QQ (GB); Sperry, John Arthur, Abingdon Oxfordshire OX14 2HJ (GB)
(74) Representative: Ackroyd, Robert

(56) References cited:
- GB-A- 2 076 826
- PATENT ABSTRACTS OF JAPAN vol. 8, no. 109 (P-275)(1546) 22 May 1984, & JP-A-59 17550
- PATENT ABSTRACTS OF JAPAN vol. 11, no. 68 (P-553)(2515) 28 February 1987, & JP-A-61 230138

## Description

The present invention relates to photopolymers and, in particular, concerns photopolymers having a high degree of photosensitivity and a marked solubility in water.

Photosensitive resin or polymer compositions, which contain or consist of at least one photopolymer, have long been used for various purposes, including the preparation of several types of printing formes, as resists for subsequent plating or etching operations, for instance in the preparation of printed circuit boards and nameplates, and in the manufacture of UV-curable inks and varnishes.

Water-soluble or water-processable resist materials are very desirable, because of their cheapness and safe handling properties, at the manufacturing stage, and the subsequent ease of processing after image-wise exposure. There is also an interest in the use of water-soluble or water-swellable photopolymers for the immobilisation of enzymes or living micro-organisms; in this type of use, only very innocuous materials may be used because it is not possible, if use is made of many other materials having an immobilisation action, to prevent damage or even destruction of the active entity.

Water-processable systems which have previously been employed in one or more of the applications mentioned above include;
(a) Dichromate-sensitised water-soluble colloids. These are now rarely used, because of the toxicity of dichromate sensitisers and the difficulty in disposing of heavy metals, in the effluent from processing laboratories, and also because of the well-known "dark reaction" which these colloids undergo and which restricts these products to a very limited shelf life.
(b) Diazo resins. These are condensation products, usually of diazodiphenylamine with formaldehyde, and may be used in a metal-free form. When mixed with suitable colloids such as polyvinylalcohol, diazo-resins give excellent results, but photographically these are rather slow and have a limited shelf-life, particularly in the presence of water.
(c) Free radical systems. A considerable number of these are described in the literature; they consist of:
   (i) A photoinitiator, which under the effect of actinic light produces free radicals capable of initiating vinyl polymerisation;
   (ii) A monomer, usually containing two or more unsaturated groups which are capable of polymerisation; the presence of more than one unsaturated group in the monomer has the effect of causing cross-linking, which increases the efficiency of the hardening reaction;
   (iii) A suitable water-processable colloid; the efficiency of the reaction can be greatly enhanced if the colloid contains substituents which enable the polymer chains to take part directly in the reactions involved, rather than simply becoming enmeshed in a matrix of cross-linked monomer.
   The disadvantages of free radical systems are that they are intrinsically oxygen-sensitive. Also, they require careful control of the moisture level, presumably in order to optimise the mobility of the component parts of the system with a view to obtaining the best photographic speed. This necessarily means that the photographic speed will vary as the moisture content changes;
(d) Photodimerisable Systems. These are best known in the form of water-insoluble compounds, typified by polyvinylcinnamate, which is widely used in commercial light-sensitive coatings. They have the very desirable property of being stable against the effects of heat, moisture and oxygen.
Several recent patent specifications describe water-soluble photodimerisable systems, which retain the desirable properties mentioned above. These systems have the advantage of direct participation in the photoreaction by the substituted polymer chains themselves, giving fast photographic speeds and great thermal stability. GB-A-2,030,575, GB-A-2,076,826 and J. Polymer Sci, Polymer Chem Edn. 1980, 18, 891-920 describe such products, produced by causing a styrylpyridine salt posessing a formyl group or an acetal group to react with polyvinylalcohol. The resulting photopolymer is completely water-soluble; also, due to the alignment of the reactive groups, the polymer has very high photo-activity, even at low levels of substitution, and this results in a greatly improved photographic speed; EP-B-0092901 describes a similar system, but the active group is a chalcone, rather than a stilbazole; chalcones are rather more easily prepared, but are not as efficient as the corresponding stilbazoles.

JP-A-59-17550 discloses derivatives of polyvinylalcohol having a structural unit of the formula 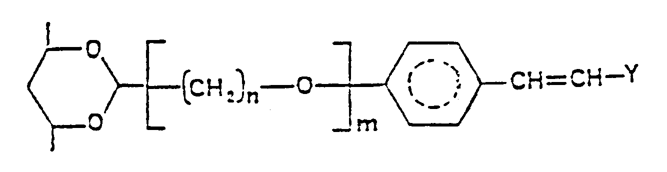
wherein n=1 and m=0 or 1 and Y is a quaternized benzothiazole group, or the naphthalene-based analogue of a quanternized benzothiazole group.

According to one aspect, the present invention provides a photosensitive polyvinylalcohol derivative, the polyvinylalcohol having a degree of hydrolysis of from 88% to 92% and the derivative incorporating a constituent of the formula: 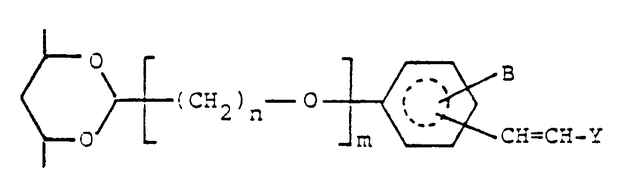
wherein: 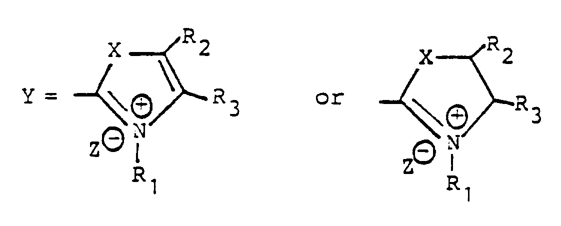
m = 0 or 1;
n = 0 or an integer from 1-6, subject to the proviso that when n=0 then m=0;
B = H or a tertiary amine, methoxy or ethoxy group; and
X = 0, S, or Se or a divalent NR₁ or C(R₁)₂ group, where R₁ = H or an alkyl, hydroxyalkyl, aryl or aralkyl group;
Z = an anion and
R₂ and R₃ are the same or different and each represents an alkyl, hydroxyalkyl, aryl, halogen, nitro or cyano group or R₂ and R₃ taken together may form part of the same aliphatic ring system.

According to another aspect of the invention, the preparation of these photopolymers is carried out by heating polyvinylalcohol having a degree of hydrolysis of from 88% to 92%, under acid conditions, with at least one compound of the general formula: 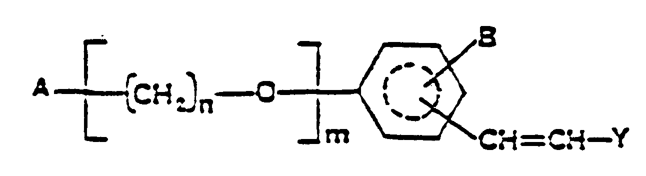
wherein A is a formyl or acetal group and m, n, B and Y have the meanings defined above; the preferred pH for the reaction is in the range from 1.0 to 4.0 and, most preferably, is about 2.0.

More than one of the intermediates having the general structure described above, but not having the same structure, may be admixed. The properties of the photopolymer may be further modified by the inclusion in the reaction mixture of one or more non-light-sensitive compounds containing a formyl or acetal group; these also co-condense during the reaction and may be used to change such properties as solubility in, or resistance to, defined solvents, adhesion to various substrates or abrasion resistance of the hardened polymer. Examples of such non-light-sensitive modifiers include acetaldehyde, acetaldehyde dimethyl or diethylacetal, chloral and chloracetaldeyde dimethyl or diethyl acetal. The polyvinylalcohol used is from 88 to 92% hydrolysed and therefore contains a number of acetyl groups. The photopolymers can be produced by treating the polyvinylalcohol, dissolved in a suitable solvent, usually water, with the one or more compounds of the formula described above and adding an acid catalyst. Examples of suitable acids include hydrochloric acid, sulphuric acid, phosphoric acid, methane-sulphonic acid and p-toluene-sulphonic acid. The reaction may be carried out at a temperature in the range from room temperature (say 20°C) to 100°C and for a time in the range from 2 to 72 hours; the preferred reaction conditions are 70°C for 4 hours. The photopolymer may be separated by precipitation in a suitable solvent, for example acetone, or the reaction mixture may be used directly, after adjustment of the pH, by application to a substrate as a photoresist. For high photoefficiency, two properties are highly desirable. First, the wavelength of maximum light absorption ^{λ}max should as nearly as possible match the maximum in the emission spectrum of the light-source used. It is of particular utility that the absorption spectrum of the photopolymers herein described lies in the range from 320-600nm and so matches the emission of most commercially-available exposure lamps. Further, the ^{λ}max can be adjusted by careful choice of structure so as to more nearly match any special requirements, such as the use of a laser source.

Secondly, it is highly desirable for the efficiency of the photoreaction to be such that the absorption of actinic light by a coated layer containing the photopolymers causes rapid destruction of the chromophore and prevents self-screening of the underlying layers by unchanged photopolymer at the surface.

The photopolymers of the present invention have a very high photo-efficiency, enabling thick layers of coated photopolymer to be adequately hardened throughout the total thickness of the coating, even though only relatively short exposure times are used, i.e. they display considerably greater photographic speed than the diazo and other systems described previously. Because the reaction involved when the photopolymers are irradiated with actinic light is photodimerisation, causing cross-linking of the polymer chains, the photoreaction exhibits none of the problems normally found with alternative systems, viz. oxygen, temperature or moisture sensitivity.

The photosensitive group need be present in only low concentrations, 0.46 to 3 mole %, based upon the polyvinylalcohol, in order to give very high levels of photosensitivity. The consequence of this is that the photopolymer retains many of the useful properties of polyvinylalcohol itself; for example, resistance to ink solvent when used as a printing forme. The photopolymers herein described can be used in any photographic or photochemical process where a resist or stencil or relief image is required, for example, as an etching resist for printing plates and cylinders, name-plates, dials etc; as resists for plating processes such as in the preparation of printed circuit boards, as ink-accepting images for lithographic plates, and as stencils for the screen printing process. The photopolymers are also very suitable for use as resists for the preparation of face-plates for cathode ray tubes, to be used for example in black and white or colour television sets. They may also be used in specialised UV-curable water-reducible inks.

The photopolymers of this invention have a special utility as immobilisers for enzymes or for living micro-organisms for the preparation of chemical products. This is because they may be photo-cross-linked at around neutral pH and under such mild conditions that only minimum damage to biological entities occurs.

They may also be used for applications where hardening by laser light sources is feasible, such as the use of laser-scanned litho-plates. In the various applications, typical ones of which are described above by way of example, the photopolymers may be internally modified, as described above, and/or they may be mixed with suitable pigments, fillers, resins or the like. The photopolymers are easily made from readily-available starting materials.

In order that the invention may be fully understood and appreciated, the following non-limitative Examples are provided by way of illustration only. In these Examples, part (c) of each of Examples 1 and 2 and part (b) of Example 3 illustrate preparation of a photopolymer of the invention, while parts (a) and (b) of each of Examples 1, 2 and 4 and part (a) of Example 3 describe the preparation of intermediates; Example 5 illustrates the use of a photopolymer composition of the invention as a photographic resist.

### Example 1

### (a) Synthesis of 4-(2,2-diethoxyethoxy)benzaldehyde

The following ingredients were charged to a round bottom flask equipped with an anchor stirrer:

| | |
|---|---|
| 4-hydroxybenzaldehyde | 122g (1 mole) |
| Sodium hydroxide | 40g (1 mole) |
| N-methylpyrrolidone | 400 ml |
| Bromoacetaldehydediethylacetal | 197g (1 mole) |

The mixture was stirred at 140°C for 16 hours to precipitate sodium bromide. After cooling, 150 ml each of water and diethylether were added with agitation. The aqueous layer was discarded and the organic layer was washed with dilute alkali to remove unreacted aldehyde. On removal of the ether, the product was distilled as a pale yellow liquid of boiling point 135°-140°C at 1-2mm Hg; yield 143g, 60%.

### (b) Synthesis of 2-[4-(2,2-diethoxyethoxy)styryl]-3,4-dimethylthiazolium methosulphate

2,4-dimethylthiazole, 53g, was dissolved in 300g of dry methanol and cooled in an ice bath. 59g of dimethylsulphate were added slowly with stirring and the mixture was allowed to rise to room temperature and then stirred for 4 hours. 99g of 4-(2,2-diethyoxyethoxy)benzaldehyde produced as described in part (a) were added, followed by 10 ml of piperidine, and the mixture was refluxed for 5 hours. 100 ml of methanol was removed by evaporation and 700 ml of hot ethylacetate added. On cooling on an ice bath, the product crystallised and was separated by filtration and then washed with ethylacetate; yield 76g, 40%.
The product is a free-flowing yellow powder of ^{λ}max = 374nm, ^{ε}max = 27,000 ℓmol⁻¹ cm⁻¹ and melting point = 152°-153°C.

| Analyses | % Calculated | % Found |
|---|---|---|
| C | 52.57 | 51.99 |
| H | 6.36 | 6.50 |
| N | 3.05 | 2.97 |
| S | 13.95 | 14.43 |

### (c) Preparation of Photopolymer

2.0g of the product was dissolved in 10g of methanol and added to 200g of a 10% aqueous solution of polyvinylalcohol, degree of polymerisation 1700 and degree of hydrolysis 88%. 3g of phosphoric acid was added and the reaction mixture was stirred at 70°C for 16 hours, followed by precipitation in a large volume of ethanol to isolate a photosensitive polyvinylalcohol derivative. After washing and drying, the polymer was analysed by UV spectrometry and found to contain 0.8 mole% of styrylthiazole groups.

### Example 2

### (a) Synthesis of 2-[4-(2,2-diethoxyethoxy)styryl]thiazoline

20.2g (0.2 mole) of 2-methylthiazoline and 47.6g of 4-(2,2-diethoxyethoxy)benzaldehyde were dissolved in 150 ml of toluene and 5g of dry zinc chloride was added. The mixture was refluxed for 16 hours and 3 ml of water was collected in a Dean and Stark trap.
After cooling, 150ml of 3N hydrochloric acid were added with agitation. The organic layer was discarded and the aqueous layer was washed with ethylacetate. On addition of 200 ml of 50% 0.88 ammonia, a solid precipitated which was filtered and recrystallised from a mixture of dichloromethane and 60-80 petroleum ether; yield 22g, 35%.

| Analyses | % Calculated | % Found |
|---|---|---|
| C | 63.52 | 63.78 |
| H | 7.21 | 7.32 |
| N | 4.36 | 4.23 |
| S | 9.97 | 9.92 |

### (b) Synthesis of 2-[4-(2,2-diethoxyethoxy)styryl]-3-methylthiazolinium methosulphate

10g of 4-(2,2-diethoxyethoxy)styrylthiazoline prepared as in part (a) were dissolved in 45 ml of ethylacetate and 3.93g of dimethylsulphate was added. The mixture was stirred at 50°C for 7 hours and the crystalline product was collected by filtration and washed with ethylacetate; yield 12g, 86%.
The product was obtained as yellow crystals of ^{λ}max = 361nm, ^{ε}max = 28,500 ℓmol⁻¹cm⁻¹ and melting point = 60°-67°C.

| Analyses | % Calculated | % Found |
|---|---|---|
| C | 50.99 | 51.07 |
| H | 6.53 | 6.68 |
| N | 3.13 | 3.21 |
| S | 14.33 | 14.35 |

### (c) Preparation of Photopolymer

1.0g of the above product was dissolved in 10g methanol and added to 200g of a 10% aqueous solution of polyvinylalcohol, degree of polymerisation 1700, degree of hydrolysis 92%. 3g of toluene-4-sulphonic acid was added and the mixture was stirred at 60°C for 48 hours. Upon precipitation in a large volume of ethanol, followed by washing and drying, a photosensitive polyvinylalcohol derivative was obtained which contained 0.53 mole% styrylthiazoline groups.

### Example 3

### (a) Synthesis of 2-[4-(2,2-diethoxyethoxy)styryl]-3-methyloxazolinium methosulphate

2-methyloxazoline, 4.26g, was dissolved in 30 ml of dry methanol and cooled in an ice bath. 6.3g of dimethylsulphate were added and the mixture was stirred at room temperature for 3 hours. 11.9g of 4-(2,2-diethoxyethoxy)benzaldehyde was added, followed by 0.5g of piperidine. The mixture was refluxed for 6 hours, followed by the addition of 100 ml of acetone to precipitate a sticky yellow solid. This was purified by dissolving in methanol followed by precipitation in acetone; yield 7g, 33%. ^{λ}max = 338nm, ^{ε}max = 10,300 ℓmol⁻¹cm⁻¹.

| Analyses | % Calculated | % Found |
|---|---|---|
| C | 53.15 | 53.02 |
| H | 6.29 | 6.40 |
| N | 3.26 | 3.35 |
| S | 7.46 | 7.32 |

### (b) Preparation of Photopolymer

0.5g of the above product was dissolved in 10g of methanol and added to 100g of a 10% solution of polyvinylalcohol, degree of polymerisation 3,500 and degree of hydrolysis 88%. 2g of concentrated hydrochloric acid was added and the mixture was stirred at 80°C for 3 hours. Upon precipitation in a large volume of ethanol, followed by washing and drying, a photosensitive polyvinylalcohol derivative was obtained, which by UV analysis contained 0.46 mole% styryloxazoline groups.

### Example 4

### (a) Synthesis of 3-(2,2-diethoxyethoxy)-4-methoxybenzaldeyde

The following ingredients were charged to a round bottom flask, equipped with an anchor stirrer:

| | |
|---|---|
| 3-hydroxy-4-methoxybenzaldehyde | 60.86g (0.4 mole) |
| Sodium hydroxide | 16.0g (0.4 mole) |
| Diglyme | 200ml |
| Bromoacetaldehydediethylacetal | 86.7g (0.44 mole) |

The mixture was stirred at 150°C for 20 hours to precipitate sodium bromide and then cooled. 150 ml each of benzene and water were added with agitation. The aqueous layer was discarded and the organic layer was washed with dilute alkali to remove unwanted aldehyde. The product was distilled under vacuum to yield a yellow oil which slowly crystallised on standing at room temperature. Boiling point 140°C at 0.3mm Hg; yield 36g, 34%.

| Analyses | % Calculated | % Found |
|---|---|---|
| C | 62.67 | 62.58 |
| H | 7.51 | 7.43 |

### (b) Synthesis of 2-[3-(2,2-diethoxyethoxy)-4-methoxystyryl]-3,4-dimethylthiazolium methosulphate

2.5g of 2,4-dimethylthiazole was dissolved in 10 ml of dry methanol and 2.8g of dimethylsulphate was added slowly with stirring. After 4 hours stirring at room temperature, 6.0g of 3-(2,2-diethoxyethoxy)-4-methoxybenzaldehyde were added, followed by 0.4 ml of piperidine. The mixture was refluxed for 4 hours, followed by the addition of 60g of hot ethylacetate, and was then cooled on an ice bath. The crystalline product was isolated by filtration and recrystallised from a mixture of isopropylalcohol and 60-80 petroleum ether; yield 3.1g, 29%. ^{λ}max = 379nm, ^{ε}max = 18,000 ℓmole⁻¹cm⁻¹ and melting point 117°-119°C.

| Analyses | % Calculated | % Found |
|---|---|---|
| C | 51.41 | 50.06 |
| H | 6.57 | 6.38 |
| N | 2.85 | 3.17 |
| S | 13.07 | 14.78 |

### Example 5

5.0g of the photosensitve polyvinylalcohol derivative prepared according to Example 1 was dissolved in 45g of distilled water by mixing on a high shear stirrer. The resulting photosensitive composition was applied to a glass plate and dried to yield a coating of thickness 20 µm. The coated glass plate was contacted with a photographic positive and exposed through the positive to a 5kW mercury vapour lamp at 1 metre distance for 20 seconds.
After washing with running water for 2 minutes, followed by drying, a relief image was obtained which was a faithful negative reproduction of the original. The resist obtained could be used as a mask for sandblasting or could be dyed by immersion in a dye-bath, to decorate the glass.

## Claims

1. A photosensitive derivative of polyvinylalcohol, said polyvinylalcohol having a degree of hydrolysis of from 88% to 92%, the polyvinylalcohol derivative incorporating a photosensitive constituent of the formula: 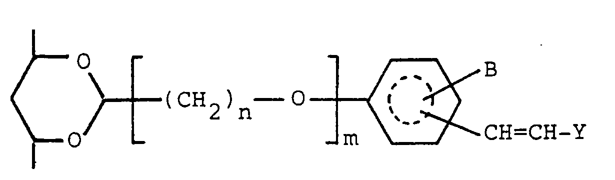 wherein: 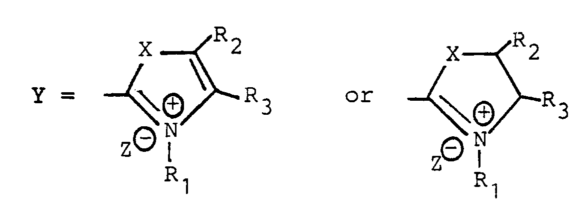 m = 0 or 1;
n = 0 or an integer from 1 to 6 subject to the proviso that when n=0 then m=0;
B = H or a tertiary amine, methoxy or ethoxy group; and
X = 0, S or Se or a divalent NR₁ or C(R₁)₂ group, where
R₁ = H or an alkyl, hydroxyalkyl, aryl or aralkyl group;
Z = an anion and
R₂ and R₃ are the same or different and each represents an alkyl, hydroxyalkyl, aryl, halogen, nitro or cyano group or R₂ and R₃ taken together may form part of the same aliphatic ring system.

2. A polyvinylalcohol derivative according to claim 1, also incorporating, as a non-photosensitive modifier, at least one constituent introduced by reaction of a compound containing a formyl group or acetal group with hydroxyl groups of the polyvinylalcohol backbone.

3. A polyvinylalcohol derivative according to claim 2, wherein the said compound is selected from acetaldehyde, acetaldehyde dimethyl acetal, acetaldehyde diethyl acetal, chloral, chloracetaldehyde dimethyl acetal and chloracetaldehyde diethyl acetal.

4. A polyvinylalcohol derivative according to any preceding claim, having an absorption spectrum in the range from 320 to 600nm.

5. A polyvinylalcohol derivative according to any preceding claim, wherein the photosensitive constituent of the stated formula is present in a concentration in the range 0.46 to 3 mole %, based upon the polyvinylalcohol in the composition.

6. A photosensitive polymer composition comprising a polyvinylalcohol derivative according to any preceding claim.

7. A photosensitive polymer composition according to claim 6, which contains two or more polyvinyalcohol derivatives incorporating respective different constituents according to the formula stated in claim 1.

8. A photosensitive polymer composition according to claim 6 or 7, containing at least one further component selected from pigments, fillers and resins.

9. A process of preparation of a photosensitive derivative of polyvinylalcohol, the derivative being according to claim 1, wherein polyvinylalcohol having a degree of hydrolysis of from 88% to 92% is heated, under acid conditions, with at least one compound of the general formula: 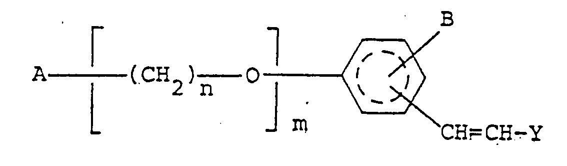 wherein A is a formyl or acetal group and m, n, B and Y having the meanings defined in claim 1.

10. A process according to claim 9, wherein the reaction is carried out at a pH in the range from 1.0 to 4.0.

11. A process according to claim 9 or 10, wherein at least one non-photosensitive modifier compound containing a formyl group or an acetal group is incorporated in the reaction mixture so as to become co-condensed during the reaction.

12. A process according to claim 11, wherein the said modifier compound is selected from acetaldehyde, acetaldehyde dimethyl acetal acetaldehyde diethylacetal, chloral, chloracetaldehyde dimethyl acetal and chloracetaldehyde diethyl acetal.

13. A process according to any of claims 9 to 12, wherein the reaction is carried out in the presence of a catalyst selected from hydrochloric acid, sulphuric acid, phosphoric acid, methane-sulphonic and p-toluene-sulphonic acid.

14. A process according to any of claims 9 to 13, wherein the reaction is carried out at a temperature in the range from room temperature to 100°C and for a time in the range from 2 to 72 hours.

15. A process according to any of claims 9 to 14, wherein the reaction is carried out so that the photosensitive constituent of the stated formula is present in a concentration in the range from 0.46 to 3 mole %, based upon the polyvinylalcohol in the composition.

## Patentansprüche

1. Fotoempfindliches Derivat eines Polyvinylalkohols, der eine Hydrolysegrad von 88 % bis 92 % aufweist, wobei das Polyvinylalkoholderivat einen fotoempfindlichen Bestandteil der folgenden Formel aufweist: 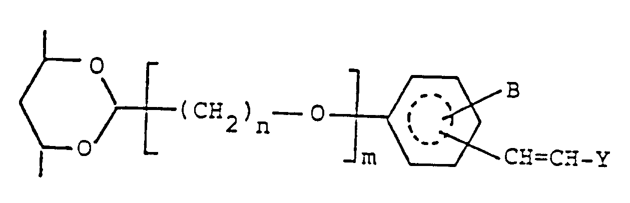 wobei 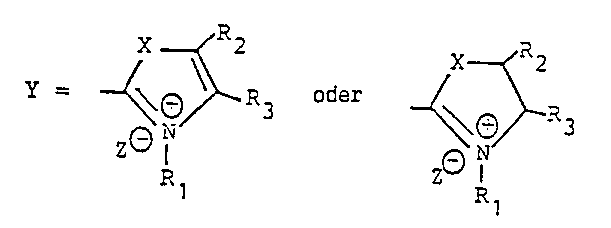 m = 0 oder 1;
n = 0 oder eine ganze Zahl von 1 bis 6 in Abhängigkeit von der Bedingung, daß, wenn n=0, daß dann m=0 ist;
B = H oder eine tertiäre Amin-, Methoxy- oder Äthoxygruppe ist; und
X = 0, S oder Se oder eine zweiwertige NR₁ oder C(R₁)₂-Gruppe ist, wobei R₁ = H oder eine Alkyl-, Hydroxyalkyl-, Aryl- oder Aralkylgruppe ist;
Z ein Anion ist und
R₂ und R₃ einander gleich oder unterschiedlich sind und jeweils eine Alkyl-, Hydroxyalkyl-, Aryl-, Halogen-, Nitro- oder Cyangruppe darstellen oder wobei R₂ und R₃ zusammengenommen einen Teil des gleichen aliphatischen Ringsystems bilden.

2. Polyvinylalkoholderivat nach Anspruch 1, welches ferner als nicht lichtempfindliches Modifiziermittel wenigstens einen Bestandteil enthält, der durch Reaktion einer, eine Formyl- oder eine Acetalgruppe enthaltenden Verbindung mit Hydroxylgruppen des Polyvinylalkoholgerüstes eingeführt worden ist.

3. Polyvinylalkoholderivat nach Anspruch 2, bei welchem die genannte Verbindung aus der folgenden Gruppe ausgewählt ist, nämlich Acetaldehyd, Acetaldehyd Dimetylacetal, Acetaldehyd Diethylacetal, Chloral, Chloracethaldehyd, Dimethylacetal und Chloracetaldehyd Diäthylacetal.

4. Polyvinylalkoholderivat nach einem der vorangegeangenen Ansprüche, welcher ein Absorptionsspektrum in dem Bereich von 320 nm bis 600 nm aufweist.

5. Polyvinylalkoholderivat nach einem der vorangegangenen Ansprüche, wobei der fotoempfindliche Bestandteil der dargestellten Formel in einer Konzentration zwischen 0,46 Mol-% bis 3 Mol-%, bezogen auf den Polyvinylalkohol in der Verbindung gegenwärtig ist.

6. Fotoempfindliche Polymerverbindung, welche ein Polyvinylalkoholderivat nach einem der vorangegangenen Ansprüche umfaßt.

7. Fotoempfindliche Polymerverbindung nach Anspruch 6, welche zwei oder mehr Polyvinylalkoholderivate umfaßt, in welche jeweils unterschiedliche Bestandteile nach der Formel gemäß Anspruch 1 eingebunden sind.

8. Fotoempfindliche Polymerverbindung nach Anspruch 6 oder 7, welche wenigstens eine weitere Komponente enthält, die aus der Gruppe Pigmente, Füllstoffe und Harze ausgewählt sind.

9. Verfahren zur Herstellung eines fotoempfindlichen Polyvinylalkoholderivats, welches dem Anspruch 1 entspricht, wobei der, einen Hydrolysegrad von 88 % bis 92 % aufweisende Polyvinylalkohol unter sauren Bedingungen erhitzt wird, und zwar mit wenigstens einer Verbindung der folgenden allgemeinen Formel: 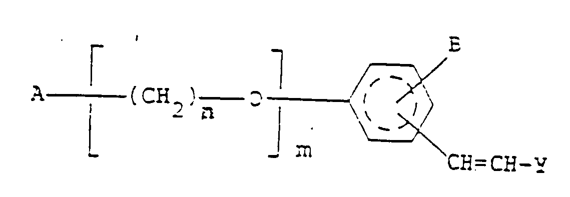 wobei A eine Formyl- oder eine Acetalgruppe ist und m, n, B und Y die in Anspruch 1 definierten Bedeutungen haben.

10. Verfahren nach Anspruch 9, wobei die Reaktion bei einem pH-Wert in dem Bereich von 1,0 bis 4,0 durchgeführt wird.

11. Verfahren nach Anspruch 9 oder 10, wobei wenigstens eine, ein nicht lichtempfindliches Modifiziermittel darstellende Verbindung, welche eine Formyl- oder eine Acetalgruppe enthält, in die Reaktionsmischung eingebunden ist und zusammen mit dieser während der Reaktion kondensiert.

12. Verfahren nach Anspruch 11, wobei die genannte, ein Modifiziermittel darstellende Verbindung aus der folgenden Gruppe ausgewählt ist, nämlich Acetaldehyd, Acetaldehyd Dimethylacetal, Acetaldehyd Diäthylacetal, Chloral, Chloracetaldehyd Dimethylacetal und Chloracetaldehyd Diäthyl Acetal.

13. Verfahren nach einem der vorangegangenen Ansprüche 9 bis 12, wobei die Reaktion in Gegenwart eines Katalysators durchgeführt wird, der aus der folgenden Gruppe ausgewählt ist, nämlich Salzsäure, Schwefelsäure, Phosphorsäure, Methansulfon und p-Toluol-Sulfonsäure.

14. Verfahren nach einem der vorangegangenen Ansprüche 9 bis 13, wobei die Reaktion bei einer Temperatur im Bereich von Raumtemperatur bis 100° C und während einer Zeitspanne in dem Bereich von 2 Stunden bis 72 Stunden ausgeführt wird.

15. Verfahren nach einem der Ansprüche 9 bis 14, wobei die Reaktion derart durchgeführt wird, daß der fotoempfindliche Bestandteil der dargestellten Formel in einer Konzentration gegenwärtig ist, die in dem Bereich von 0,46 Mol-% bis 3 Mol-% liegt, bezogen auf den Polyvinylalkohol in der Verbindung.

## Revendications

1. Dérivé photosensible du poly(alcool vinylique), ledit poly(alcool vinylique) ayant un degré d'hydrolyse de 88 à 92 %, le dérivé du poly(alcool vinylique) comprenant un constituant photosensible ayant la formule suivante : 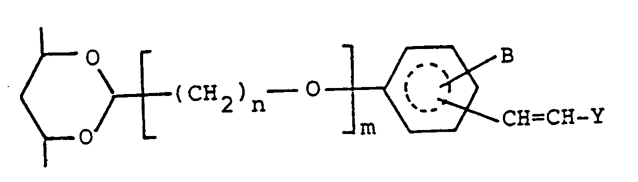 où 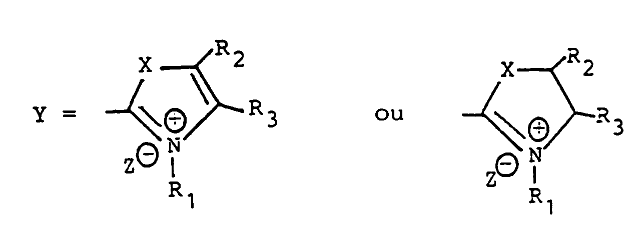 m = 0 ou 1 ;
n = 0 ou est un entier de 1 à 6, du moment que, quand n = 0, alors m = 0 ;
B = H ou est une amine tertiaire ou un groupe méthoxy ou éthoxy ; et
X = 0, S ou Se ou est un groupe divalent NR₁ ou C(R₁)₂ où R₁ = H ou est un radical alkyle, hydroxyalkyle, aryle ou aralkyle ;
Z est un anion et
R₂ et R₃ sont identiques ou différents et représentent chacun un groupe alkyle, hydroxyalkyle, aryle, halogéno, nitro ou cyano, ou encore R₂ et R₃, pris ensemble, peuvent former une partie du même système cyclique aliphatique.

2. Dérivé du poly(alcool vinylique) selon la revendication 1, qui comprend aussi, en tant que modifiant non photosensible, au moins un constituant introduit par la réaction d'un composé contenant un groupe formyle ou acétal avec des groupes hydroxyle de l'ossature du poly(alcool vinylique).

3. Dérivé du poly(alcool vinylique) selon la revendication 2, dans lequel le composé est choisi parmi l'acétaldéhyde, l'acétal diméthylique de l'acétaldéhyde, l'acétal diéthylique de l'acétaldéhyde, le chloral, l'acétal diméthylique du chloracétaldéhyde et l'acétal diéthylique du chloracétaldéhyde.

4. Dérivé du poly(alcool vinylique) selon l'une quelconque des revendications précédentes, qui présente un spectre d'absorption compris entre 320 et 600 nm.

5. Dérivé du poly(alcool vinylique) selon l'une quelconque des revendications précédentes, dans lequel le constituant photosensible ayant la formule ci-dessus est présent selon une concentration de 0,46 à 3 % en moles par rapport au poly(alcool vinylique) se trouvant dans la composition.

6. Composition polymère photosensible comprenant un dérivé du poly(alcool vinylique) selon l'une quelconque des revendications précédentes.

7. Composition polymère photosensible selon la revendication 6, qui contient au moins deux dérivés du poly(alcool vinylique), qui comprennent les différents constituants selon la formule de la revendication 1.

8. Composition polymère photosensible selon la revendication 6 ou 7, qui contient au moins un autre composant choisi parmi les pigments, les charges et les résines.

9. Procédé pour préparer un dérivé photosensible du poly(alcool vinylique), ce dérivé correspondant à la revendication 1, dans lequel on chauffe dans des conditions acides un poly(alcool vinylique) ayant un degré d'hydrolyse de 88 à 92 %, avec au moins un composé de formule générale 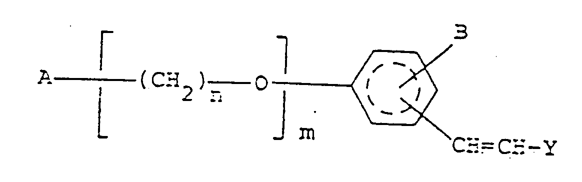 dans laquelle A est un groupe formyle ou acétal, et m, n, B et Y ont les significations données dans la revendication 1.

10. Procédé selon la revendication 9, dans lequel la réaction est mise en oeuvre à un pH compris entre 1,0 et 4,0.

11. Procédé selon la revendication 9 ou 10, dans lequel on incorpore dans le mélange réactionnel au moins un composé modifiant non photosensible contenant un groupe formyle ou un groupe acétal, de façon à le co-condenser pendant la réaction.

12. Procédé selon la revendication 11, dans lequel le composé modifiant est choisi parmi l'acétaldéhyde, l'acétal diméthylique de l'acétaldéhyde, l'acétal diéthylique de l'acétaldéhyde, le chloral, l'acétal diméthylique du chloracétaldéhyde et l'acétal diéthylique du chloracétaldéhyde.

13. Procédé selon l'une quelconque des revendications 9 à 12, dans lequel la réaction est mise en oeuvre en présence d'un catalyseur choisi parmi l'acide chlorhydrique, l'acide sulfurique, l'acide phosphorique, l'acide méthanesulfonique et l'acide paratoluènesulfonique.

14. Procédé selon l'une quelconque des revendications 9 à 13, dans lequel la réaction est mise en oeuvre à une température comprise entre la température ambiante et 100°C pendant un laps de temps de 2 à 72 heures.

15. Procédé selon l'une quelconque des revendications 9 à 14, dans lequel la réaction est mise en oeuvre de façon que le constituant photosensible ayant la formule ci-dessus soit présent selon une concentration de 0,46 à 3 % en moles par rapport au poly(alcool vinylique) se trouvant dans la composition.
